# EUROPEAN PATENT APPLICATION

(11) **EP 2 448 004 A1**
(43) Date of publication of application: **02.05.2012**
(21) Application number: 11185800.7
(22) Date of filing: 19.10.2011
(51) Int. Cl.: H01L 31/0296, H01L 31/18, H01L 31/073, C23C 14/06

(54) **Intermixing of cadmium sulfide layers and cadmium telluride layers for thin film photovoltaic devices and methods of their manufacture**

(30) Priority: 27.10.2010 US 913419
(71) Applicant: PrimeStar Solar, Inc, Arvada, CO 80004 (US)
(72) Inventor: Feldman-Peabody, Scott Daniel, Arvada, CO Colorado 80004 (US); Pavol, Mark Jeffrey, Arvada, CO Colorado 80004 (US)
(74) Representative: Bedford, Grant Richard

(57) **Abstract**

Cadmium telluride thin film photovoltaic devices 10 are generally disclosed including an intermixed layer 19 of cadmium sulfide and cadmium telluride between a cadmium sulfide layer 18 and a cadmium telluride layer 20. The intermixed layer 19 generally has an increasing tellurium concentration and decreasing sulfur concentration extending in a direction from the cadmium sulfide layer 18 towards the cadmium telluride layer 20. Methods are also generally disclosed for manufacturing a cadmium telluride based thin film photovoltaic device 10 having an intermixed layer 19 of cadmium sulfide and cadmium telluride.

## Description

The subject matter disclosed herein relates generally to intermixed thin film layers containing cadmium sulfide and cadmium telluride, along with their methods of deposition. More particularly, the subject matter disclosed herein relates to intermixed thin film layers of cadmium sulfide and cadmium telluride for use in cadmium telluride thin film photovoltaic devices and their methods of manufacture.

Thin film photovoltaic (PV) modules (also referred to as "solar panels") based on cadmium telluride (CdTe) paired with cadmium sulfide (CdS) as the photo-reactive components are gaining wide acceptance and interest in the industry. CdTe is a semiconductor material having characteristics particularly suited for conversion of solar energy to electricity. For example, CdTe has an energy bandgap of about 1.45 eV, which enables it to convert more energy from the solar spectrum as compared to lower bandgap semiconductor materials historically used in solar cell applications (e.g., about 1.1 eV for silicon). Also, CdTe converts radiation energy in lower or diffuse light conditions as compared to the lower bandgap materials and, thus, has a longer effective conversion time over the course of a day or in cloudy conditions as compared to other conventional materials.

The junction of the n-type layer and the p-type layer is generally responsible for the generation of electric potential and electric current when the CdTe PV module is exposed to light energy, such as sunlight. Specifically, the cadmium telluride (CdTe) layer and the cadmium sulfide (CdS) form a p-n heterojunction, where the CdTe layer acts as a p-type layer (i.e., a positive, electron accepting layer) and the CdS layer acts as a n-type layer (i.e., a negative, electron donating layer). Free carrier pairs are created by light energy and then separated by the p-n heterojunction to produce an electrical current.

Intermixing at the surfaces of the cadmium sulfide and cadmium telluride layers can occur during the annealing process after deposition of the cadmium telluride layer. This intermixing can increase the minority carrier lifetime in the cadmium telluride, thereby increasing the open circuit voltage (Voc) and the fill factor, and therefore the efficiency of the device. However, intermixing caused by the annealing process is dependent upon several manufacturing variables including the annealing temperature, length of anneal, thin film and surface uniformity (especially at the p-n junction), dopant concentration(s), annealing atmosphere (e.g., humidity), etc. These manufacturing variables can create problems in forming substantially uniform PV devices during a large scale manufacturing process, resulting in varying efficiencies of the manufactured PV devices.

Thus, a need exists for cadmium telluride photovoltaic devices having improved p-n junctions defined by controlled intermixed layers of cadmium sulfide and cadmium telluride.

Various aspects and advantages of the invention will be set forth in part in the following description, or may be clear from the description, or may be learned through practice of the invention.

Cadmium telluride thin film photovoltaic devices are generally disclosed including an intermixed layer of cadmium sulfide and cadmium telluride between a cadmium sulfide layer and a cadmium telluride layer. The intermixed layer generally has an increasing tellurium concentration and decreasing sulfur concentration extending in a direction from the cadmium sulfide layer towards the cadmium telluride layer.

Methods are also generally disclosed for manufacturing a cadmium telluride based thin film photovoltaic device having an intermixed layer of cadmium sulfide and cadmium telluride.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

Various aspects and embodiments of the present invention are set forth in the following specification, which makes reference to the appended figures, in which:
Fig. 1 shows a general schematic of a cross-sectional view of an exemplary cadmium telluride thin film photovoltaic device according to one embodiment of the present invention;
Fig. 2 shows an exemplary embodiment of an intermixed layer of cadmium sulfide and cadmium telluride defined by a single graded layer having increasing tellurium concentration and decreasing sulfur concentration through the thickness of the graded telluride layer extending from the cadmium sulfide layer to the cadmium telluride layer;
Fig. 3 shows another exemplary embodiment of an intermixed layer of cadmium sulfide and cadmium telluride formed step-wise such that a plurality of layers of increasing tellurium content and decreasing sulfur content define the intermixed layer;
Fig. 4 shows yet another exemplary embodiment of an intermixed layer of cadmium sulfide and cadmium telluride formed from digital layers of alternating CdS layers and CdTe layers where the CdS layers decrease in thickness as the CdTe layers increase in thickness through the thickness of the intermixed layer extending from the cadmium sulfide layer to the cadmium telluride layer; and
Fig. 5 shows a flow diagram of an exemplary method of manufacturing a photovoltaic module including a cadmium telluride thin film photovoltaic device.

Repeat use of reference characters in the present specification and drawings is intended to represent the same or analogous features or elements.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

In the present disclosure, when a layer is being described as "on" or "over" another layer or substrate, it is to be understood that the layers can either be directly contacting each other or have another layer or feature between the layers. Thus, these terms are simply describing the relative position of the layers to each other and do not necessarily mean "on top of" since the relative position above or below depends upon the orientation of the device to the viewer. Additionally, although the invention is not limited to any particular film thickness, the term "thin" describing any film layers of the photovoltaic device generally refers to the film layer having a thickness less than about 10 micrometers ("microns" or "µm").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

Generally speaking, cadmium telluride thin film photovoltaic devices are presently disclosed having an intermixed layer of cadmium sulfide and cadmium telluride (CdTe/CdS), along with methods of their manufacture. The intermixed layer of CdTe/CdS can be positioned between a cadmium sulfide layer and the cadmium telluride layer. The intermixed layer can be formed during the deposition process, prior to annealing the cadmium telluride layer, to better control the stoichiometry of the junction of the cadmium sulfide layer and cadmium telluride layer. Additionally, the uniformity of the junction formed in individual devices throughout the manufacturing process can be better controlled.

The intermixed layer of CdTe/CdS can generally have an increasing tellurium concentration and decreasing sulfur concentration extending from the cadmium sulfide layer towards the back contact layer, although several configurations can be utilized to form such an intermixed layer.

The thickness of the intermixed layer can be configured to adjust and tailor the interaction and/or electrical field between the cadmium sulfide layer and the cadmium telluride layer. In most embodiments, the intermixed layer of CdTe/CdS can have a thickness less than the thickness of the cadmium telluride layer. For example, the thickness of the intermixed layer of CdTe/CdS can be between about 0.01 µm and about 1 µm, for example between about 10 nm to about 500 nm or from about 50 nm to about 250 nm.

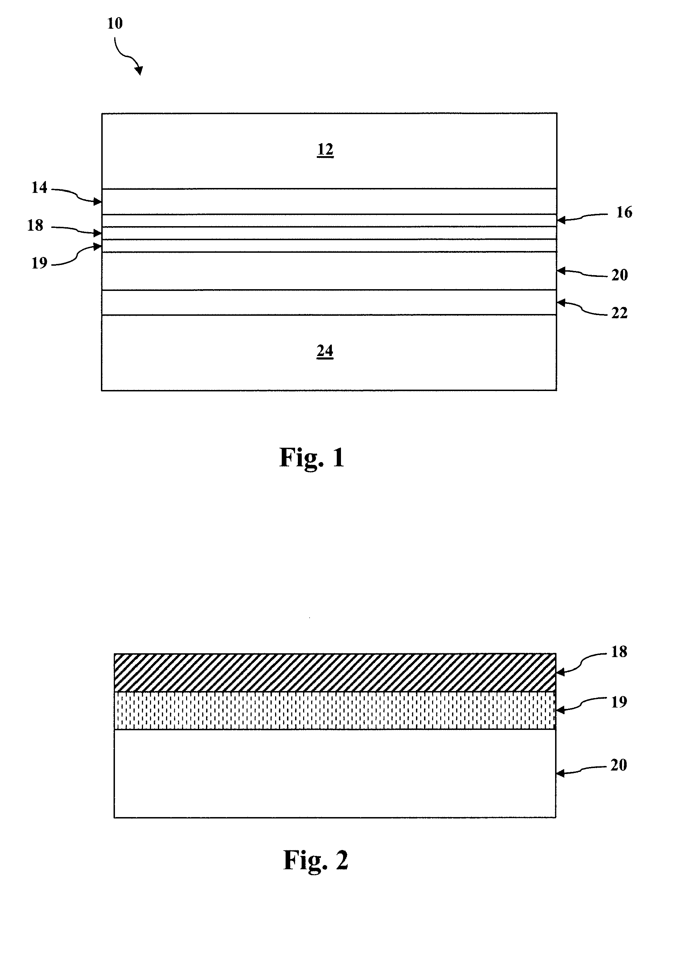

Fig. 1 represents an exemplary cadmium telluride thin film photovoltaic device 10 having an intermixed layer 19 of CdTe/CdS positioned between a cadmium sulfide layer 18 and a cadmium telluride layer 20. In the embodiment shown in Fig. 2, for example, the intermixed layer 19 of CdTe/CdS is defined by a single thin film layer that is graded to have an increasing tellurium concentration and decreasing sulfur concentration through the thickness of the intermixed layer 19 extending from the cadmium sulfide layer 18 to the cadmium telluride layer 20. For example, the intermixed layer 19 of CdTe/CdS can be represented as a CdS₁₋ₓTeₓ layer, where 0 < x ≤ 1, with increasing tellurium content (i.e., increasing the value of x) through the thickness of the intermixed layer 19 extending from the cadmium sulfide layer 18 to the cadmium telluride layer 20. In one particular embodiment, the junction of the cadmium sulfide layer 18 and the intermixed layer 19 is primarily CdS and substantially free from tellurium (i.e., CdS₁₋ₓTeₓ, where x is about 0), and the opposite surface of the intermixed layer 19, which contacts the cadmium telluride layer 20, is primarily CdTe and substantially free from sulfur (e.g., CdS₁₋ₓTeₓ, where x is about 1). As used herein, the term "substantially free" means no more than an insignificant trace amount present and encompasses completely free (e.g., 0 molar % up to 0.0001 molar %).

In one embodiment, the increasing tellurium concentration and decreasing sulfur concentration may be a linear change (i.e., a substantially constant rate of change) through the thickness of the graded intermixed layer 19 extending from the cadmium sulfide layer 18 to the cadmium telluride layer 20. Alternatively, the rate of increasing tellurium concentration and decreasing sulfur concentration may be varied throughout the graded intermixed layer 19. For example, the rate of increasing tellurium concentration and decreasing sulfur concentration may be relatively slow (e.g., x increasing to about 0.25 or less, such as x increasing to about 0.05 to about 0.1) through the first half of the thickness, while the rate of increasing tellurium concentration and decreasing sulfur concentration may be relatively fast through the second half of the thickness. Conversely, the rate of increasing tellurium concentration and decreasing sulfur concentration may be relatively fast (e.g., x increasing to about 0.75 or more, such as x increasing to about 0.8 to about 0.9) through the first half of the thickness, while the rate of increasing tellurium concentration and decreasing sulfur concentration may be relatively slow through the second half of the thickness.

The intermixed layer 19 can be formed according to any process, such as co-sputtering (e.g., from a first target of cadmium sulfide and a second target of cadmium telluride), co-evaporation (e.g., from a first source of cadmium sulfide and a second source of cadmium telluride), reactive sputtering, metal-organic chemical vapor deposition (MOCVD), etc.

For example, reactive sputtering could be utilized to form the cadmium sulfide layer 18, then by introducing a tellurium gas source (e.g., diethyltellurium, diisopropyltelluride, or other suitable tellurium gases, or mixtures thereof) to the sputtering chamber to form an intermixed layer including tellurium into the deposited layer (e.g., in the same sputtering chamber or in a sequential sputtering chamber(s)). The tellurium concentration in the deposited layer can be increased by increasing the amount of tellurium in the sputtering atmosphere. For example, the tellurium concentration in the sputtering atmosphere can be increased linearly, to provide for a linear increase in the tellurium concentration of the deposited intermixed layer 19 extending away from the cadmium sulfide layer 18. In one embodiment, the tellurium concentration in the sputtering atmosphere can be increased to about 100% by volume, such as about 75% to about 95% by volume.

Conversely, the intermixed layer 19 can be formed by reactive sputtering a cadmium telluride target in the presence of a sulfur-containing source gas (e.g., sulfur gas, hydrogen sulfide, carbon disulfide, sulfur tetrafluoride, sulfur hexafluoride, sulfur dichloride, disulfur dichloride, dimethyl sulfide, tetrasulfur tetranitride, alkane thiols, thioethers, or other suitable sulfur-containing gases, or mixtures thereof). The sputtering atmosphere in this embodiment can have a relatively high sulfur gas concentration (e.g., about 90% to 100% by volume) upon beginning sputtering the intermixed layer that decreases during the sputtering process. For instance, an inert gas (e.g., argon) can be introduced into the sputtering chamber as the sulfur-containing source gas is consumed by the reactive sputtering and/or vacuumed out of the sputtering chamber.

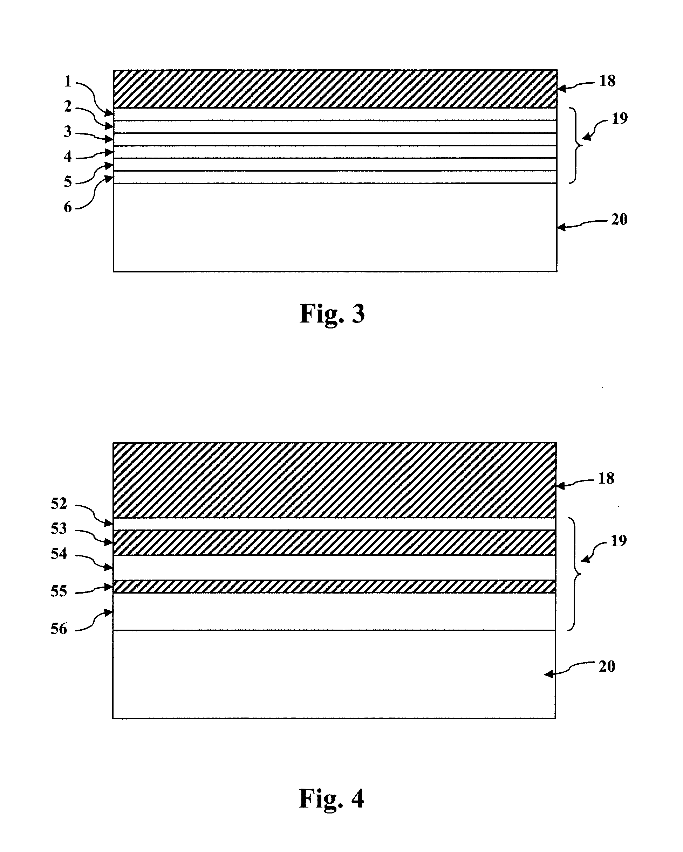

Fig. 3 shows another embodiment of an intermixed layer 19 that includes a plurality of intermixed layers of increasing tellurium content (layers 1-6, respectively) formed step-wise to collectively define the intermixed layer 19. Each individual layer 1-6 has an increasing tellurium content and decreasing sulfur content, relative to the prior deposited layer, such that layer 2 has more tellurium content and less sulfur content than layer 1, layer 3 has more tellurium content and less sulfur content than layer 2, layer 4 has more tellurium content and less sulfur content than layer 3, layer 5 has more tellurium content and less sulfur content than layer 4, and layer 6 has more tellurium content and less sulfur content than layer 5. For instance, layer 1 can have a structure of CdS₁₋ₓTeₓ, where 0 < x ≤ 0.2; layer 2 can have a structure of CdS₁₋ₓTeₓ, where 0.2 ≤ x ≤0.4; layer 3 can have a structure of CdS₁₋ₓTeₓ, where 0.4 ≤ x ≤ 0.6; layer 4 can have a structure of CdS₁₋ₓTeₓ, where 0.6 ≤ x ≤ 0.8; layer 5 can have a structure of CdS₁₋ₓTeₓ, where 0.8 ≤ x < 1; and layer 6 can have a structure of CdS₁₋ₓTeₓ, where x is about 1. As such, in one particular embodiment, the junction of the cadmium sulfide layer 18 and the layer 1 is primarily CdS (i.e., CdS₁₋ₓTeₓ, where x is 0), and the junction of the intermixed layer 19 and the cadmium telluride layer 20 is substantially free from sulfur (e.g., CdS₁₋ₓTeₓ, where x is 1).

Although the exemplary step-wise intermixed layer 19 shown in Fig. 3 has six layers 1-6, any number of step-wise layers can be used to form the intermixed layer 19. For example, the intermixed layer can be formed, in one particular embodiment, from three intermixed layers: a first layer closest to the cadmium sulfide layer, a second layer on the first layer, and a third layer on the second layer, wherein the first layer comprises CdS₁₋ₓTeₓ, where 0 ≤ x ≤ 0.2; the second layer comprises CdS₁₋ₓTeₓ, where 0.2 < x < 0.8; and, the third layer comprises CdS₁₋ₓTeₓ, where 0.8 ≤ x ≤ 1. In another example, the intermixed layer can be formed from three intermixed layers: a first layer closest to the window layer, a second layer on the first layer, and a third layer on the second layer, wherein the first layer comprises CdS₁-ₓTeₓ, where 0 ≤ x ≤, 0.1; the second layer (e.g., a transition layer) comprises CdS₁₋ₓTeₓ, where 0.1 ≤ x ≤ 0.9; and, the third layer comprises CdS₁₋ₓTeₓ, where 0.9 ≤ x ≤ 1. In yet another embodiment, the intermixed layer can be defmed as a bilayer, including a first layer closest to the window layer and comprising CdS₁₋ₓTeₓ, where 0 ≤ x ≤ 0.1; and a second layer adjacent to the cadmium telluride layer and comprising CdS₁₋ₓTeₓ, where 0.9 ≤ x ≤ 1.

Additionally, each of the layers 1-6 can be formed of varying thickness, such as from about 1 nm to about 250 nm in thickness. In certain embodiments, the thickness of each of the layers 1-6 can be from about 10 nm to about 100 nm, for example from about 10 nm to about 50 nm. In one embodiment, each of the layers 1-6 can have substantially the same thickness.

The step-wise plurality of layers 1-6 can generally form the intermixed layer 19 upon annealing the device 10 (e.g., post-deposition of the cadmium telluride layer 20). For example, the device 10 can be annealed in the presence of cadmium chloride (CdCl₂), such as after deposition of the cadmium telluride layer 20. Annealing the device 10 can be performed by heating to an anneal temperature (e.g., about 150° C to about 600° C). In one embodiment, particularly when the intermixed layer 19 of CdTe/CdS is formed from a plurality of step-wise layers 1-6 as shown in Fig. 3, the cadmium telluride layer 20 and intermixed layer 19 of CdTe/CdS can be annealed less severely, such as at an anneal temperature of about 200° C to about 450° C, such as about 350° C to about 420° C, for less than about 60 minutes, such as from about 30 seconds to about 30 minutes. Without wishing to be bound by any particular theory, it is believed that the less severe anneal can form the intermixed layer 19 of CdTe/CdS from the plurality of layers 1-6 without completely diffusing the cadmium telluride layer 20 into the cadmium sulfide layer 18. The formation of the plurality of layers 1-6 can allow for better control (e.g., stoichiometric control) of the intermixed layer 19 formed post anneal, rather than relying on the mixing of the cadmium sulfide layer 18 and the cadmium telluride layer 20 at the junction surfaces.

The plurality of layers 1-6 can be formed according to any process, such as co-sputtering (e.g., from a first target of cadmium sulfide and a second target of cadmium telluride), co-evaporation (e.g., from a first source of cadmium sulfide and a second source of cadmium telluride), reactive sputtering, metal-organic chemical vapor deposition (MOCVD), etc, as discussed above.

Fig. 4 shows yet another embodiment of a intermixed layer 19 formed from digital layers of alternating CdS layers 53, 55 and CdTe layers 52, 54, 56 with the CdS layers 53, 55 decreasing in thickness as the CdTe layers 52, 54, 56 increase in thickness through the thickness of the intermixed layer 19 extending from the cadmium sulfide layer 18 to the cadmium telluride layer 20. In one particular embodiment, each of the cadmium sulfide digital layers includes CdS₁₋ₓTeₓ, where 0 ≤ x ≤ 0.1 (e.g., substantially pure CdS), and each of the cadmium telluride digital layers includes CdS₁₋ₓTeₓ, where 0.9 ≤ x ≤ 1 (e.g., substantially pure CdTe). For instance, each of the CdS layers 53, 55 are substantially free from tellurium (i.e., CdS₁₋ₓTeₓ, where x is 0), and each of the CdTe layers 52, 54, 56 is substantially free from sulfur (e.g., CdS₁₋ₓTeₓ, where x is 1). Upon annealing, such as described above, with respect to the step-wise layers 1-6, the digital layers 52-56 can intermix into the intermixed layers 19. As such, the digital layers of alternating CdS layers 53, 55 and CdTe layers 52, 54, 56 with the CdS layers 53, 55 decreasing in thickness as the CdTe layers 52, 54, 56 increase in thickness through the thickness of the intermixed layer 19 form a graded structure where the tellurium concentration increases and the sulfur concentration decreases through the thickness of the intermixed layer 19 extending from the cadmium sulfide layer 18 to the cadmium telluride layer 20. Although shown with five digital layers (i.e., first CdS layer 53 and second CdS layer 55 in combination with first CdTe layer 52, second CdTe layer 54, and third CdTe layer 56), any number of digital layers can be used to form the intermixed layer 19.

The digital layers 52-56 can be formed according to any process, such as co-sputtering (e.g., from a first target of cadmium sulfide and a second target of cadmium telluride), co-evaporation (e.g., from a first source of cadmium sulfide and a second source of cadmium telluride), reactive sputtering, metal-organic chemical vapor deposition (MOCVD), etc, as discussed above.

The exemplary device 10 of Fig. 1 includes a top sheet of glass 12 employed as the substrate. In this embodiment, the glass 12 can be referred to as a "superstrate", as it is the substrate on which the subsequent layers are formed even though it faces upward to the radiation source (e.g., the sun) when the cadmium telluride thin film photovoltaic device 10 is in used. The top sheet of glass 12 can be a high-transmission glass (e.g., high transmission borosilicate glass), low-iron float glass, or other highly transparent glass material. The glass is generally thick enough to provide support for the subsequent film layers (e.g., from about 0.5 mm to about 10 mm thick), and is substantially flat to provide a good surface for forming the subsequent film layers. In one embodiment, the glass 12 can be a low iron float glass containing less than about 0.15% by weight iron (Fe), and may have a transmissiveness of about 0.9 or greater in the spectrum of interest (e.g., wavelengths from about 300 nm to about 900 nm).

A transparent conductive oxide (TCO) layer 14 is shown on the glass 12 of the exemplary device 10 of Fig. 1. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). The TCO layer 14 generally includes at least one conductive oxide, such as tin oxide, zinc oxide, or indium tin oxide, or mixtures thereof. Additionally, the TCO layer 14 can include other conductive, transparent materials. The TCO layer 14 can also include zinc stannate and/or cadmium stannate.

The TCO layer 14 can be formed by sputtering, chemical vapor deposition, spray pyrolysis, or any other suitable deposition method. In one particular embodiment, the TCO layer 14 can be formed by sputtering (e.g., DC sputtering or RF sputtering) on the glass 12. For example, a cadmium stannate layer can be formed by sputtering a hot-pressed target containing stoichiometric amounts of Sn0₂ and CdO onto the glass 12 in a ratio of about 1 to about 2. The cadmium stannate can alternatively be prepared by using cadmium acetate and tin (II) chloride precursors by spray pyrolysis.

In certain embodiments, the TCO layer 14 can have a thickness between about 0.1 µm and about 1 µm, for example from about 0.1 µm to about 0.5 µm, such as from about 0.25 µm to about 0.35 µm. Suitable flat glass substrates having a TCO layer 14 formed on the superstrate surface can be purchased commercially from various glass manufactures and suppliers. For example, a particularly suitable glass 12 including a TCO layer 14 includes TEC 15 glass commercially available under the name TEC 15 TCO from Pilkington North America Inc. (Toledo, Ohio), which includes a TCO layer having a sheet resistance of 15 ohms per square.

A resistive transparent buffer layer 16 (RTB layer) is shown on the TCO layer 14 on the exemplary cadmium telluride thin film photovoltaic device 10 of Fig. 1. The RTB layer 16 is generally more resistive than the TCO layer 14 and can help protect the device 10 from chemical interactions between the TCO layer 14 and the subsequent layers during processing of the device 10. For example, in certain embodiments, the RTB layer 16 can have a sheet resistance that is greater than about 1000 ohms per square, such as from about 10 kohms per square to about 1000 MOhms per square. The RTB layer 16 can also have a wide optical bandgap (e.g., greater than about 2.5 eV, such as from about 2.7 eV to about 3.5 eV).

Without wishing to be bound by a particular theory, it is believed that the presence of the RTB layer 16 between the TCO layer 14 and the cadmium sulfide layer 18 can allow for a relatively thin cadmium sulfide layer 18 to be included in the device 10 by reducing the possibility of interface defects (i.e., "pinholes" in the cadmium sulfide layer 18) creating shunts between the TCO layer 14 and the cadmium telluride layer 20. Thus, it is believed that the RTB layer 16 allows for improved adhesion and/or interaction between the TCO layer 14 and the cadmium telluride layer 20, thereby allowing a relatively thin cadmium sulfide layer 18 to be formed thereon without significant adverse effects that would otherwise result from such a relatively thin cadmium sulfide layer 18 formed directly on the TCO layer 14.

The RTB layer 16 can include, for instance, a combination of zinc oxide (ZnO) and tin oxide (Sn0₂), which can be referred to as a zinc tin oxide layer ("ZTO"). In one particular embodiment, the RTB layer 16 can include more tin oxide than zinc oxide. For example, the RTB layer 16 can have a composition with a stoichiometric ratio of ZnO/SnO₂ between about 0.25 and about 3, such as in about an one to two (1:2) stoichiometric ratio of tin oxide to zinc oxide. The RTB layer 16 can be formed by sputtering, chemical vapor deposition, spray-pyrolysis, or any other suitable deposition method. In one particular embodiment, the RTB layer 16 can be formed by sputtering (e.g., DC sputtering or RF sputtering) on the TCO layer 14. For example, the RTB layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas). When the oxidizing atmosphere includes oxygen gas (i.e., O₂), the atmosphere can be greater than about 95% pure oxygen, such as greater than about 99%.

In certain embodiments, the RTB layer 16 can have a thickness between about 0.075 µm and about 1 µm, for example from about 0.1 µm to about 0.5 µm. In particular embodiments, the RTB layer 16 can have a thickness between about 0.08 µm and about 0.2 µm, for example from about 0.1 µm to about 0.15 µm.

A cadmium sulfide layer 18 is shown on RTB layer 16 of the exemplary device 10 of Fig. 1. The cadmium sulfide layer 18 is a n-type layer that generally includes cadmium sulfide (CdS) but may also include other materials, such as zinc sulfide, cadmium zinc sulfide, etc., and mixtures thereof as well as dopants and other impurities. In one particular embodiment, the cadmium sulfide layer may include oxygen up to about 25% by atomic percentage, for example from about 5% to about 20% by atomic percentage. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering (e.g., direct current (DC) sputtering or radio frequency (RF) sputtering) on the RTB layer 16. Sputtering deposition generally involves ejecting material from a target, which is the material source, and depositing the ejected material onto the substrate to form the film. DC sputtering generally involves applying a current to a metal target (i.e., the cathode) positioned near the substrate (i.e., the anode) within a sputtering chamber to form a direct-current discharge. The sputtering chamber can have a reactive atmosphere (e.g., an oxygen atmosphere, nitrogen atmosphere, fluorine atmosphere) that forms a plasma field between the metal target and the substrate. The pressure of the reactive atmosphere can be between about 1 mTorr and about 20 mTorr for magnetron sputtering. When metal atoms are released from the target upon application of the voltage, the metal atoms can react with the plasma and deposit onto the surface of the substrate. For example, when the atmosphere contains oxygen, the metal atoms released from the metal target can form a metallic oxide layer on the substrate. The current applied to the source material can vary depending on the size of the source material, size of the sputtering chamber, amount of surface area of substrate, and other variables. In some embodiments, the current applied can be from about 2 amps to about 20 amps. Conversely, RF sputtering generally involves exciting a capacitive discharge by applying an alternating-current (AC) or radiofrequency (RF) signal between the target (e.g., a ceramic source material) and the substrate. The sputtering chamber can have an inert atmosphere (e.g., an argon atmosphere) having a pressure between about 1 mTorr and about 20 mTorr.

Due to the presence of the RTB layer 16, the cadmium sulfide layer 18 can have a thickness that is less than about 0.1 µm, such as between about 10 nm and about 100 nm, such as from about 50 nm to about 80 nm, with a minimal presence of pinholes between the TCO layer 14 and the cadmium sulfide layer 18. Additionally, a cadmium sulfide layer 18 having a thickness less than about 0.1 µm reduces any absorption of radiation energy by the cadmium sulfide layer 18, effectively increasing the amount of radiation energy reaching the underlying cadmium telluride layer 20.

The intermixed layer 19, as discussed above, is shown on the cadmium sulfide layer 18.

A cadmium telluride layer 20 is shown on the intermixed layer 19 in the exemplary cadmium telluride thin film photovoltaic device 10 of Fig. 1. The cadmium telluride layer 20 is a p-type layer that generally includes cadmium telluride (CdTe) but may also include other materials. As the p-type layer of device 10, the cadmium telluride layer 20 is the photovoltaic layer that interacts with the cadmium sulfide layer 18 (i.e., the n-type layer) to produce current from the adsorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the cadmium telluride layer 20) across the junction to the n-type side (i.e., the cadmium sulfide layer 18) and, conversely, holes may pass from the n-type side to the p-type side. Thus, the p-n junction formed between the cadmium sulfide layer 18 and the cadmium telluride layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 µm and about 10 µm, such as from about 1 µm and about 5 µm. In one particular embodiment, the cadmium telluride layer 20 can have a thickness between about 1.5 µm and about 4 µm, such as about 2 µm to about 3 µm.

A series of post-forming treatments can be applied to the exposed surface of the cadmium telluride layer 20. These treatments can tailor the functionality of the cadmium telluride layer 20 and prepare its surface for subsequent adhesion to the back contact layer(s) 22. For example, the cadmium telluride layer 20 can be annealed at elevated temperatures (e.g., from about 350° C to about 500° C, such as from about 375° C to about 425° C) for a sufficient time (e.g., from about 1 to about 40 minutes) to create a quality p-type layer of cadmium telluride. Without wishing to be bound by theory, it is believed that annealing the cadmium telluride layer 20 (and the device 10) decreases the deep-defect density and makes the CdTe layer more p-type. Additionally, the cadmium telluride layer 20 can recrystallize and undergo grain regrowth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride then annealed at the elevated temperature.

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing oxides from the surface, such as CdO, CdTe0₃, CdTe₂0₅, etc. For instance, the surface can be washed with a suitable solvent (e.g., ethylenediamine also known as 1,2 diaminoethane or "DAE") to remove any cadmium oxide from the surface.

Additionally, copper can be added to the cadmium telluride layer 20. Along with a suitable etch, the addition of copper to the cadmium telluride layer 20 can form a surface of copper-telluride on the cadmium telluride layer 20 in order to obtain a low-resistance electrical contact between the cadmium telluride layer 20 (i.e., the p-type layer) and the back contact layer(s). Specifically, the addition of copper can create a surface layer of cuprous telluride (Cu₂Te) between the cadmium telluride layer 20 and the back contact layer 22 and/or can create a Cu-doped CdTe layer. Thus, the Te-rich surface of the cadmium telluride layer 20 can enhance the collection of current created by the device through lower resistivity between the cadmium telluride layer 20 and the back contact layer 22.

Copper can be applied to the exposed surface of the cadmium telluride layer 20 by any process. For example, copper can be sprayed or washed on the surface of the cadmium telluride layer 20 in a solution with a suitable solvent (e.g., methanol, water, or the like, or combinations thereof) followed by annealing. In particular embodiments, the copper may be supplied in the solution in the form of copper chloride, copper iodide, or copper acetate. The annealing temperature is sufficient to allow diffusion of the copper ions into the cadmium telluride layer 20, such as from about 125° C to about 300° C (e.g. from about 150° C to about 250° C) for about 5 minutes to about 30 minutes, such as from about 10 to about 25 minutes.

A back contact layer 22 is shown on the cadmium telluride layer 20. The back contact layer 22 generally serves as the back electrical contact, in relation to the opposite, TCO layer 14 serving as the front electrical contact. The back contact layer 22 can be formed on, and in one embodiment is in direct contact with, the cadmium telluride layer 20. The back contact layer 22 is suitably made from one or more highly conductive materials, such as elemental nickel, chromium, copper, tin, silver, or alloys or mixtures thereof. Additionally, the back contact layer 22 can be a single layer or can be a plurality of layers. In one particular embodiment, the back contact layer 22 can include graphite, such as a layer of carbon deposited on the p-layer followed by one or more layers of metal, such as the metals described above. The back contact layer 22, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 µm to about 10 µm in thickness, for example from about 1 µm to about 5 µm. A metal layer of the back contact, if used for or as part of the back contact layer 22, can be from about 0.1 µm to about 1.5 µm in thickness.

The encapsulating glass 24 is also shown in the exemplary cadmium telluride thin film photovoltaic device 10 of Fig. 1.

Other components (not shown) can be included in the exemplary device 10, such as buss bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor such as a wire or bus bar, to direct the photovoltaically generated current to convenient locations for connection to a device or other system using the generated electric. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells.

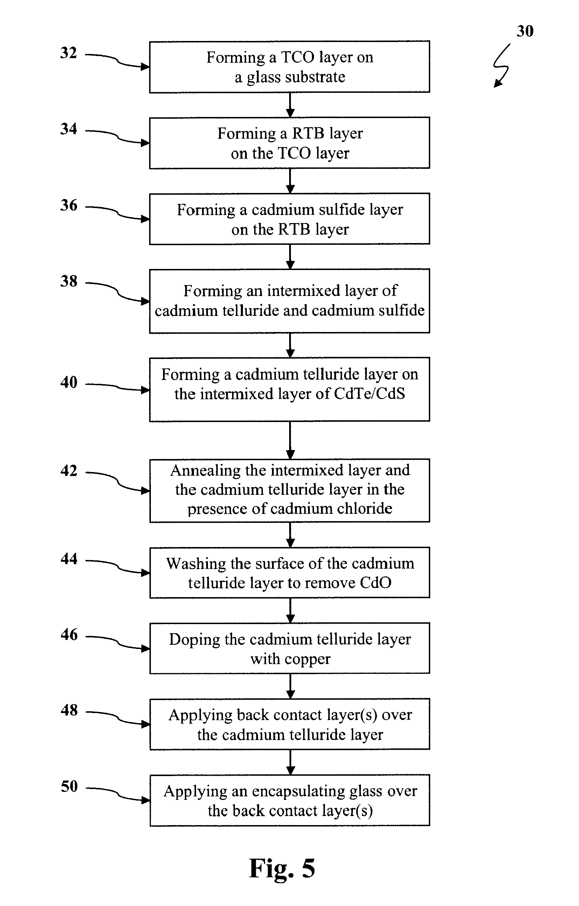

Fig. 5 shows a flow diagram of an exemplary method 30 of manufacturing a photovoltaic device according to one embodiment of the present invention. According to the exemplary method 30, a TCO layer is formed on a glass substrate at 32. At 34, a RTB layer is formed on the TCO layer. A cadmium sulfide layer is formed on the RTB layer at 36. An intermixed layer of cadmium telluride and cadmium sulfide can then be formed on the cadmium sulfide layer at 38. A cadmium telluride layer can then be formed on the intermixed layer at 40. The cadmium telluride layer and the intermixed layer can be annealed in the presence of cadmium chloride at 42. The cadmium telluride layer can then be washed at 44 to remove any CdO formed on the surface, and doped with copper at 46. At 48, back contact layer(s) can be applied over the cadmium telluride layer, and an encapsulating glass can be applied over the back contact layer at 50.

One of ordinary skill in the art should recognize that other processing and/or treatments can be included in the method 30. For instance, the method may also include laser scribing to form electrically isolated photovoltaic cells in the device. These electrically isolated photovoltaic cells can then be connected in series to form a photovoltaic module. Also, electrical wires can be connected to positive and negative terminals of the photovoltaic module to provide lead wires to harness electrical current produced by the photovoltaic module.

This written description uses examples to disclose the invention, including the preferred mode, and also to enable any person skilled in the art to practice the invention, including making and using any devices or systems and performing any incorporated methods. The patentable scope of the invention is defmed by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A cadmium telluride thin film photovoltaic device, comprising:
   a cadmium sulfide layer;
   an intermixed layer of cadmium sulfide and cadmium telluride on the cadmium sulfide layer; and,
   a cadmium telluride layer on the intermixed layer;
   wherein the intermixed layer has an increasing telluride concentration and decreasing sulfur concentration extending in a direction from the cadmium sulfide layer towards the cadmium telluride layer.
2. The cadmium telluride thin film photovoltaic device as in clause 1, wherein the intermixed layer comprises CdS₁₋ₓTeₓ, where x is about 0 adjacent to the cadmium sulfide layer and where x is about 1 adjacent to the cadmium telluride layer.
3. The cadmium telluride thin film photovoltaic device as in any preceding clause, wherein the intermixed layer is defined by a single graded layer comprising CdS₁₋ₓTeₓ, where 0 < x < 1.
4. The cadmium telluride thin film photovoltaic device as in any preceding clause, wherein the increasing tellurium concentration and decreasing sulfur concentration is substantially linear through the thickness of the intermixed layer extending in the direction from the cadmium sulfide layer towards the cadmium telluride layer.
5. The cadmium telluride thin film photovoltaic device as in any preceding clause, wherein the intermixed layer is formed step-wise and comprises a plurality of layers of increasing tellurium content and decreasing sulfur content as the layers become closer to the cadmium telluride layer.
6. The cadmium telluride thin film photovoltaic device as in any preceding clause, wherein the intermixed layer comprises a first layer closest to the cadmium sulfide layer, a second layer on the first layer, a third layer on the second layer, a fourth layer on the third layer, and a fifth layer on the fourth layer, and wherein the second layer has more tellurium content and less sulfur content than the first layer, the third layer has more tellurium content and less sulfur content than second layer, the fourth layer has more tellurium content and less sulfur content than third layer, the fifth layer has more tellurium content and less sulfur content than fourth layer.
7. The cadmium telluride thin film photovoltaic device as in any preceding clause, wherein the intermixed layer comprises a first layer directly on the cadmium sulfide layer, a second layer on the first layer, and a third layer on the second layer and adjacent to the cadmium telluride layer, wherein the first layer comprises CdS₁₋ₓTeₓ, where 0 ≤ x ≤ 0.2; the second layer comprises CdS₁₋ₓTeₓ, where 0.2 ≤ x ≤ 0.8; and, the third layer comprises CdS₁₋ₓTeₓ, where 0.8 ≤ x ≤ 1.
8. The cadmium telluride thin film photovoltaic device as in any preceding clause, wherein the intermixed layer comprises alternating cadmium sulfide digital layers and cadmium telluride digital layers such that the cadmium sulfide digital layers decrease in thickness as the cadmium telluride digital layers increase in thickness through the thickness of the intermixed layer extending in the direction from the cadmium sulfide layer towards the cadmium telluride layer.
9. The cadmium telluride thin film photovoltaic device as in any preceding clause, wherein each of the cadmium sulfur digital layers comprises CdS₁₋ₓTeₓ, where 0 ≤ x ≤ 0.1, and wherein each of the cadmium telluride digital layers comprise CdS₁₋ₓTeₓ, where 0.9 ≤ x ≤ 1.
10. A method for manufacturing a cadmium telluride based thin film photovoltaic device having an intermixed layer, the method comprising:
   forming an intermixed layer of cadmium sulfide and cadmium telluride directly on a cadmium sulfur layer, wherein the intermixed layer has an increasing tellurium concentration and decreasing sulfur concentration extending away from the cadmium sulfide layer; and
   forming a cadmium telluride layer on the intermixed layer.
11. The method as in any preceding clause, further comprising:
   annealing the device at an anneal temperature of about 150°C to about 600°C.
12. The method as in any preceding clause, wherein the intermixed layer is formed by co-sputtering from a cadmium sulfide target and a cadmium telluride target.
13. The method as in any preceding clause, wherein the increasing tellurium concentration and decreasing sulfur concentration is substantially linear through the thickness of the intermixed layer extending in the direction from the cadmium sulfide layer towards the cadmium telluride layer.
14. The method as in any preceding clause, wherein the intermixed layer is sputtered from a target in a sputtering atmosphere, wherein the target comprises cadmium sulfide, and wherein the sputtering atmosphere comprises a tellurium gas source in an increasing concentration so as to increase the tellurium concentration of the intermixed layer extending away from the cadmium sulfide layer during formation of the intermixed layer.
15. The method as in any preceding clause, wherein the intermixed layer is sputtered from a target in a sputtering atmosphere, wherein the target comprises cadmium telluride, and wherein the sputtering atmosphere comprises a sulfur gas source in a decreasing concentration so as to decrease the sulfur concentration of the intermixed layer extending away from the cadmium sulfide layer during formation of the intermixed layer.
16. The method as in any preceding clause, wherein forming the intermixed layer comprises forming alternating cadmium sulfide digital layers and cadmium telluride digital layers on the cadmium sulfide layer such that the cadmium sulfide digital layers decrease in thickness as the cadmium telluride digital layers increase in thickness through the thickness of the intermixed layer extending away from the cadmium sulfide layer.
17. The method as in any preceding clause, further comprising:
   annealing the device at an anneal temperature of about 150° C to about 600° C to mix the alternating cadmium sulfide digital layers and cadmium telluride digital layers into the intermixed layer.
18. The method as in any preceding clause, wherein each of the cadmium sulfur digital layers comprises CdS₁₋ₓTeₓ, where 0 ≤ x ≤ 0.1, and wherein each of the cadmium telluride digital layers comprise CdS₁₋ₓTeₓ, where 0.9 ≤ x ≤ 1.
19. A method for manufacturing a cadmium telluride based thin film photovoltaic device having a graded intermixed structure, the method comprising:
   forming a cadmium sulfide layer on a substrate;
   forming a plurality of intermixed layers of cadmium sulfide and cadmium telluride step-wise directly on the cadmium sulfide layer such that the plurality of intermixed layers have an increasing tellurium content and decreasing sulfur content as the layers extend away from the cadmium sulfide layer;
   forming a cadmium telluride layer on the plurality of intermixed layers; and
   annealing the device at an anneal temperature of about 150°C to about 600°C.
20. The method as in any preceding clause, wherein forming the plurality of the intermixed layers of cadmium sulfide and cadmium telluride stepwise directly on the cadmium sulfide layer comprises:
   forming a first layer closest to the cadmium sulfide layer, wherein the first layer comprises CdS₁₋ₓTeₓ, where 0 ≤ x ≤ 0.2;
   forming a second layer on the first layer, wherein the second layer comprises CdS₁₋ₓTeₓ, where 0.2 ≤ x ≤ 0.8; and
   forming a third layer on the second layer, wherein the third layer comprises CdS₁₋ₓTeₓ, where 0.8 ≤ x ≤ 1.

## Claims

1. A cadmium telluride thin film photovoltaic device (10), comprising:
a cadmium sulfide layer (18);
an intermixed layer (19) of cadmium sulfide and cadmium telluride on the cadmium sulfide layer (18); and
a cadmium telluride layer (20) on the intermixed layer (18);
wherein the intermixed layer (18) has an increasing telluride concentration and decreasing sulfur concentration extending in a direction from the cadmium sulfide layer (18) towards the cadmium telluride layer (20).

2. The cadmium telluride thin film photovoltaic device (10) as in claim 1, wherein the intermixed layer (19) comprises CdS₁₋ₓTeₓ, where x is about 0 adjacent to the cadmium sulfide layer (18) and where x is about 1 adjacent to the cadmium telluride layer (20).

3. The cadmium telluride thin film photovoltaic device (10) as in claim 1 or 2, wherein the intermixed layer (19) is defmed by a single graded layer comprising CdS₁₋ₓTeₓ, where 0 < x < 1.

4. The cadmium telluride thin film photovoltaic device (10) as in any preceding claim, wherein the increasing tellurium concentration and decreasing sulfur concentration is substantially linear through the thickness of the intermixed layer (19) extending in the direction from the cadmium sulfide layer (18) towards the cadmium telluride layer (20).

5. The cadmium telluride thin film photovoltaic device (10) as in any preceding claim, wherein the intermixed layer (19) is formed step-wise and comprises a plurality of layers of increasing tellurium content and decreasing sulfur content as the layers become closer to the cadmium telluride layer (20).

6. The cadmium telluride thin film photovoltaic device (10) as in any preceding claim, wherein the intermixed layer (19) comprises a first layer (1) closest to the cadmium sulfide layer (18), a second layer (2) on the first layer (1), a third layer (3) on the second layer (2), a fourth layer (4) on the third layer (3), and a fifth layer (5) on the fourth layer (4), and wherein the second layer (2) has more tellurium content and less sulfur content than the first layer (1), the third layer (3) has more tellurium content and less sulfur content than second layer (2), the fourth layer (4) has more tellurium content and less sulfur content than third layer (3), the fifth layer (5) has more tellurium content and less sulfur content than fourth layer (4).

7. The cadmium telluride thin film photovoltaic device (10) as in any preceding claim, wherein the intermixed layer (19) comprises a first layer directly on the cadmium sulfide layer (18), a second layer on the first layer, and a third layer on the second layer and adjacent to the cadmium telluride layer (20), wherein the first layer comprises CdS₁₋ₓTeₓ, where 0 ≤ x ≤ 0.2; the second layer comprises CdS₁₋ₓTeₓ, where 0.2 ≤ x ≤ 0.8; and, the third layer comprises CdS₁₋ₓTeₓ, where 0.8 ≤ x ≤ 1.

8. The cadmium telluride thin film photovoltaic device (10) as in any preceding claim, wherein the intermixed layer (19) comprises alternating cadmium sulfide digital layers and cadmium telluride digital layers such that the cadmium sulfide digital layers decrease in thickness as the cadmium telluride digital layers increase in thickness through the thickness of the intermixed layer (19) extending in the direction from the cadmium sulfide layer (18) towards the cadmium telluride layer (20).

9. The cadmium telluride thin film photovoltaic device (10) as in any preceding claim, wherein each of the cadmium sulfur digital layers comprises Cd_{S1-x}Teₓ, where 0 ≤ x ≤ 0.1, and wherein each of the cadmium telluride digital layers comprise CdS₁₋ₓTeₓ, where 0.9 ≤ x ≤ 1.

10. A method for manufacturing a cadmium telluride based thin film photovoltaic device (10) having an intermixed layer (19), the method comprising:
forming an intermixed layer (19) of cadmium sulfide and cadmium telluride directly on a cadmium sulfur layer (18), wherein the intermixed layer (19) has an increasing tellurium concentration and decreasing sulfur concentration extending away from the cadmium sulfide layer (18); and
forming a cadmium telluride layer (20) on the intermixed layer (19).

11. The method as in claim 10, further comprising:
annealing the device (10) at an anneal temperature of about 150° C to about 600° C.

12. The method as in claim 10 or claim 11, wherein the intermixed layer (19) is formed by co-sputtering from a cadmium sulfide target and a cadmium telluride target.

13. The method as in any of claims 10 to 12, wherein the intermixed layer (19) is sputtered from a target in a sputtering atmosphere, wherein the target comprises cadmium sulfide, and wherein the sputtering atmosphere comprises a tellurium gas source in an increasing concentration so as to increase the tellurium concentration of the intermixed layer (19) extending away from the cadmium sulfide layer (18) during formation of the intermixed layer (19).

14. The method as in any of claims 10 to 13, wherein the intermixed layer (19) is sputtered from a target in a sputtering atmosphere, wherein the target comprises cadmium telluride, and wherein the sputtering atmosphere comprises a sulfur gas source in a decreasing concentration so as to decrease the sulfur concentration of the intermixed layer (19) extending away from the cadmium sulfide layer (18) during formation of the intermixed layer (19).

15. The method as in any of claims 10 to 14, wherein forming the intermixed layer (18) comprising forming a plurality of layers of cadmium sulfide and cadmium telluride stepwise directly on the cadmium sulfide layer (18) comprises:
forming a first layer closest to the cadmium sulfide layer (18), wherein the first layer comprises CdS₁₋ₓTeₓ, where 0 ≤ x ≤ 0.2;
forming a second layer on the first layer, wherein the second layer comprises CdS₁₋ₓTeₓ, where 0.2 ≤ x ≤ 0.8; and
forming a third layer on the second layer, wherein the third layer comprises CdS₁₋ₓTeₓ, where 0.8 ≤ x ≤ 1.
